# EUROPÄISCHE PATENTSCHRIFT

(11) **EP 3 189 527 B1**
(45) Veröffentlichungstag und Bekanntmachung des Hinweises auf die Patenterteilung: **08.07.2020**
(21) Anmeldenummer: 15759720.4
(22) Anmeldetag: 31.08.2015
(51) Int. Cl.: H01C 1/028, H01C 1/148, H01C 7/02, H01C 7/04, H01C 7/10, H01C 7/18, H01G 4/232, H01G 4/30, H01G 4/224, H05K 1/16, H05K 1/03, H05K 1/18, H01C 7/112

(54) **ELEKTRISCHES BAUELEMENT, BAUELEMENTANORDNUNG UND VERFAHREN ZUR HERSTELLUNG EINES ELEKTRISCHEN BAUELEMENTS SOWIE EINER BAUELEMENTANORDNUNG**
ELECTRICAL COMPONENT , ELECTRICAL COMPONENT ASSEMBLY AND METHODS FOR MANUFACTURING THESE
COMPOSANT ÉLECTRIQUE, AGENCEMENT DE COMPOSANT ÉLECTRIQUE ET MÉTHODES DE LEUR FABRICATION

(30) Priorität: 03.09.2014 DE 102014112678
(43) Veröffentlichungstag der Anmeldung: 12.07.2017
(73) Patentinhaber: TDK Electronics AG, 81671 München (DE)
(72) Erfinder: FEICHTINGER, Thomas, 8010 Graz (AT)
(74) Vertreter: Epping - Hermann - Fischer
(86) Internationale Anmeldenummer: PCT/EP2015/069855
(87) Internationale Veröffentlichungsnummer: WO 2016/034539

(56) Entgegenhaltungen:
- WO-A1-2013/087243
- JP-A- 2002 100 875
- JP-A- 2010 080 703
- US-A1- 2012 019 099
- US-A1- 2014 174 800

## Beschreibung

Es wird ein elektrisches Bauelement mit einem keramischen Grundkörper angegeben. Das elektrische Bauelement ist zur Einbettung in einen Träger, insbesondere eine Leiterplatte, ausgebildet. Weiterhin wird eine Bauelementanordnung mit einem Träger und einem darin eingebetteten Bauelement angegeben.

Die Druckschrift WO 2013/087243 A1 beschreibt ein elektrisches Bauelement aufweisend einen keramischen Grundkörper, eine elektrisch isolierende Passivierungsschicht, Innenelektroden und eine Außenelektrode, die mit den Innenelektroden verbunden ist, wobei die Außenelektrode eine erste Elektrodenschicht aus Metall und eine darauf angeordnete zweite Elektrodenschicht in Form einer flexiblen Metallkompositschicht aufweist.

Es ist eine Aufgabe der vorliegenden Erfindung, ein elektrisches Bauelement anzugeben, dass sich zur Einbettung in einen Träger eignet.

Ein elektrisches Bauelement gemäß der Erfindung ist mit den Merkmalen des Anspruchs 1 definiert, eine Bauelementanordnung ist mit den Merkmalen des Anspruchs 6 definiert, ein Verfahren zur Herstellung des elektrischen Bauelements ist mit den Merkmalen des Anspruchs 13 definiert und ein Verfahren zur Herstellung einer Bauelementanordnung ist mit den Merkmalen des Anspruchs 14 definiert.

Gemäß einem ersten Aspekt der vorliegenden Erfindung wird ein elektrisches Bauelement zur Einbettung in einen Träger angegeben. Insbesondere handelt es sich bei dem Träger um eine Leiterplatte. Das elektrische Bauelement weist einen keramischen Grundkörper auf, auf dem eine elektrisch isolierende Passivierungsschicht aufgebracht ist. Im Grundkörper ist wenigstens eine Innenelektrode angeordnet. Die Innenelektrode führt insbesondere aus dem Grundkörper heraus- und durch die Passivierungsschicht hindurch.

Auf der Passivierungsschicht ist wenigstens eine Außenelektrode angeordnet, die mit der Innenelektrode verbunden ist. Die Außenelektrode weist eine erste Elektrodenschicht und eine darauf aufgebrachte zweite Elektrodenschicht auf. Die zweite Elektrodenschichte ist eine Kupferschicht. Vorzugsweise ist die zweite Elektrodenschicht direkt auf der ersten Elektrodenschicht angeordnet.

Eine derartige Kombination einer Passivierungsschicht mit einer ersten Elektrodenschicht und einer darauf aufgebrachten Kupferschicht gewährleistet einen zuverlässigen Schutz des Grundkörpers vor chemischen und mechanischen Einflüssen. Beispielsweise ist der Grundkörper vor Feuchte und Prozessmedien geschützt, die bei einer Einbettung in einem Träger, insbesondere in einem Laminierungsprozess, vorhanden sein können. Zudem wird eine zuverlässige Kontaktierung der Innenelektroden, beispielsweise durch kupferhaltige Durchkontaktierungen durch den Träger ermöglicht.

Beispielsweise weist die Passivierungsschicht Glas auf. Alternativ kann die Passivierungsschicht beispielsweise eine Keramik aufweisen. Beispielsweise handelt es sich bei der Passivierungsschicht um eine eingebrannte Schicht.

In einer Ausführungsform weist die erste Elektrodenschicht eine eingebrannte Paste auf. Die erste Elektrodenschicht weist beispielsweise Silber oder Silber-Palladium auf. Eine derartige Elektrodenschicht gewährleistet eine besonders zuverlässige Kontaktierung der Innenelektroden, insbesondere von Silber oder Silber-Palladium haltigen Innenelektroden.

Gemäß der Erfindung ist die zweite Elektrodenschicht in einem galvanischen oder elektrochemischen Verfahren aufgebracht. Dabei wird ein Metall aus einer Lösung auf der ersten Elektrodenschicht abgeschieden. Bei einem galvanischen Verfahren wird hierzu eine äußere Stromquelle angeschlossen. Die erste Elektrodenschicht fungiert beispielsweise als Kathode. Bei einem elektrochemischen Verfahren wird das Metall stromlos abgeschieden.

Die zweite Elektrodenschicht kann zur Verbindung mit einer Weiterkontaktierung aus Kupfer ausgebildet sein.

Die zweite Elektrodenschicht kann die äußerste Schicht der Außenelektrode sein. Dementsprechend kann die zweite Außenelektrode frei von einer oberhalb der zweiten Elektrodenschicht angeordneten Schutzschicht sein.

Gemäß einem weiteren Aspekt der vorliegenden Erfindung wird eine Bauelementanordnung angegeben. Die Bauelementanordnung weist das oben beschriebene elektrische Bauelement auf. Weiterhin weist die Bauelementanordnung einen Träger, insbesondere in Form einer Leiterplatte auf, in dem das Bauelement eingebettet ist. Das Bauelement kann teilweise oder vollständig im Träger eingebettet sein. Beispielsweise ist das Bauelement auf allen Seiten vom Material des Trägers umgeben.

Der Träger weist beispielsweise mehrere, übereinander angeordnete Schichten auf. Das Bauelement ist beispielsweise in wenigstens eine der Schichten eingebettet ist. Beispielsweise ist der Träger in einem Laminierungsprozess hergestellt. In einer Ausführungsform sind die Schichten als Polymerschichten ausgebildet. Die Schichten können Epoxidharz aufweisen.

In einer Ausführungsform weist der Träger wenigstens eine Durchkontaktierung zur elektrischen Kontaktierung des Bauelements auf. Die Durchkontaktierung führt insbesondere zumindest durch eine Schicht des Trägers hindurch.

In einer Ausführungsform enthält die Durchkontaktierung Kupfer. Dies ermöglicht einen besonders zuverlässigen elektrischen Kontakt zum Bauelement, insbesondere da die zweite Elektrodenschicht ebenfalls Kupfer enthält. Zudem weist Kupfer eine besonders gute thermische Leitfähigkeit auf. Die Durchkontaktierung kann in einem galvanischen Verfahren oder in einem elektrochemischen Verfahren hergestellt sein.

In einer Ausführungsform weist die Bauelementanordnung wenigstens einen Anschlusskontakt auf, der auf einer Außenseite des Trägers angeordnet ist. Der Anschlusskontakt ist mit der Durchkontaktierung verbunden. In einer Ausführungsform enthält der Anschlusskontakt Kupfer. Vorzugsweise weisen der Anschlusskontakt, die Durchkontaktierung und die zweite Elektrodenschicht das gleiche Material, insbesondere Kupfer, auf. Dies ermöglicht eine besonders zuverlässige elektrische und thermische Anbindung.

Gemäß einem weiteren Aspekt der vorliegenden Erfindung wird ein Verfahren zur Herstellung eines elektrischen Bauelements, insbesondere des oben beschriebenen Bauelements, angegeben. Dabei wird ein keramischer Grundkörper, aufweisend Innenelektroden bereitgestellt. Der Grundkörper ist von einer elektrisch isolierenden Passivierungsschicht umgeben. Es wird eine erste Elektrodenschicht auf die Passivierungsschicht aufgebracht. Anschließend wird eine zweite, kupferhaltige Elektrodenschicht mittels eines galvanischen oder elektrochemischen Verfahrens auf die erste Elektrodenschicht aufgebracht.

Weiterhin wird ein Verfahren zur Herstellung einer Bauelementanordnung, insbesondere der oben beschriebenen Bauelementanordnung, angegeben. Dabei wird ein elektrisches Bauelement nach dem oben beschriebenen Verfahren hergestellt. Es werden Schichten zur Ausbildung eines Trägers bereitgestellt, wobei wenigstens eine Schicht eine Aussparung aufweist. Die Schichten werden übereinander angeordnet, wobei das Bauelement in der Aussparung angeordnet wird. Anschließend werden die Schichten verpresst, so dass ein Laminat gebildet wird.

Zur Herstellung einer Durchkontaktierung wird beispielsweise in wenigstens eine Schicht ein Loch eingebracht. Beispielsweise wird das Loch in das Laminat eingebracht. Dies kann mittels eines Lasers erfolgen. Anschließend wird das Loch mit einem elektrisch leitfähigen Material aufgefüllt.

Die zweite Elektrodenschicht kann die äußerste Schicht einer Außenelektrode sein.

In der vorliegenden Offenbarung sind mehrere Aspekte einer Erfindung beschrieben. Alle Eigenschaften, die in Bezug auf das Bauelement, die Bauelementanordnung oder die Verfahren offenbart sind, sind auch entsprechend in Bezug auf die jeweiligen anderen Aspekte offenbart und umgekehrt, auch wenn die jeweilige Eigenschaft nicht explizit im Kontext des jeweiligen Aspekts erwähnt wird.

Im Folgenden werden die hier beschriebenen Gegenstände anhand von schematischen und nicht maßstabsgetreuen Ausführungsbeispielen näher erläutert.

Es zeigen:
- Figur 1: in einer schematischen Schnittansicht einen Ausschnitt eines keramischen Bauelements,
- Figur 2: eine Bauelementanordnung aufweisend das Bauelement aus Figur 1 und einen Träger.

Vorzugsweise verweisen in den folgenden Figuren gleiche Bezugszeichen auf funktionell oder strukturell entsprechende Teile der verschiedenen Ausführungsformen.

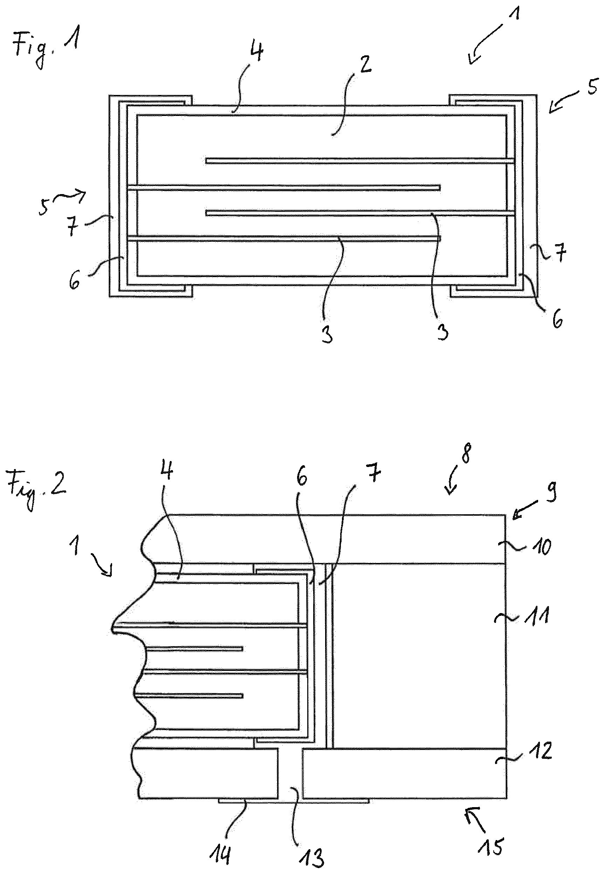

Figur 1 zeigt ein elektrisches Bauelement 1 in einer schematischen Schnittansicht. Das elektrische Bauelement 1 umfasst einen Grundkörper 2, der quaderförmig ausgeführt ist und ein Keramikmaterial aufweist. Alternativ dazu sind auch andere Bauformen möglich. Im gezeigten Ausführungsbeispiel ist das Keramikmaterial eine Varistorkeramik, insbesondere eine ZnO-Bi-Keramik. Alternativ kann es sich bei dem Keramikmaterial auch um eine NTC- oder PTC-Keramik, insbesondere um eine Thermistorkeramik oder um eine dielektrische Kondensatorkeramik handeln, je nachdem ob das elektrische Bauelement 1 als Varistor, als Thermistor oder als Kondensator ausgeführt ist.

Das elektrische Bauelement 1 weist weiterhin Innenelektroden 3 auf, die beispielsweise Silber-Palladium enthalten. Alternativ können die Innenelektroden 3 auch andere Metalle, wie zum Beispiel Nickel und/oder Kupfer, aufweisen oder daraus bestehen. Die Innenelektroden 3 sind in der Keramik des Grundkörpers 2 angeordnet und führen aus dem Grundkörper 2 heraus. Beispielsweise handelt es sich bei dem elektrischen Bauelement 1 um ein keramisches Vielschichtbauelement, bei dem die Innenelektroden 3 auf verschiedene Keramikschichten aufgedruckt und mit diesen versintert sind.

Des Weiteren weist das elektrische Bauelement 1 eine elektrisch isolierende Passivierungsschicht 4 auf. Beispielsweise enthält die Passivierungsschicht Glas oder ein Keramikmaterial. Vorzugsweise unterscheidet sich das Keramikmaterial vom Keramikmaterial des Grundkörpers 2. Die elektrisch isolierende Passivierungsschicht 4 ist vorzugsweise unmittelbar auf den Grundkörper 2 aufgebracht. Vorteilhafterweise schützt die Passivierungsschicht 4 das elektrische Bauelement 1 gegen mechanische und/oder chemische Einflüsse, die beispielsweise beim Einbringen des Bauelements 1 in einen Träger vorhanden sind.

Die Innenelektroden 3 führen durch die Passivierungsschicht 4 hindurch. Die Passivierungsschicht 4 umgibt die Keramik des Grundkörpers 2 beispielsweise vollständig außer an den Stellen, an denen die Innenelektroden 3 hindurchgeführt sind.

Auf der Passivierungsschicht 4 sind Außenelektroden 5 angeordnet. Die Außenelektroden 5 sind auf zwei gegenüberliegenden Seiten des Grundkörpers 2 angeordnet und sind jeweils über die Seitenkanten auf die angrenzenden Seiten des Grundkörpers 2 geführt. Die Außenelektroden 5 weisen jeweils eine erste Elektrodenschicht 6 und eine darauf angeordnete zweite Elektrodenschicht 7 auf.

Die erste Elektrodenschicht 6 ist aus einer eingebrannten Metallpaste gebildet. Beispielsweise weist die erste Elektrodenschicht 6 Silber auf. Die Elektrodenschicht 6 kann gemäß einem weiteren Ausführungsbeispiel auch andere Metalle, wie zum Beispiel Kupfer, aufweisen.

Die zweite Elektrodenschicht 7 ist durch Abscheiden eines Metalls aus einer Lösung aufgebracht. Das Metall enthält oder ist beispielsweise Kupfer. Zur Abscheidung des Metalls wird beispielsweise ein galvanisches Verfahren verwendet. In einer anderen Ausführungsform wird das Metall stromlos, insbesondere chemisch, abgeschieden.

Die zweite Elektrodenschicht 7 ist mit einer Weiterkontaktierung aus Kupfer kompatibel. Insbesondere ist das elektrische Bauelement 1 zur Einbettung in das Laminat einer Leiterplatte ausgebildet. Durch die Passivierungsschicht 4 ist der Grundkörper 2 unter anderem auch vor einer chemischen Kupferlösung geschützt, die zur Herstellung der zweiten Elektrodenschicht 7 verwendet wird.

Figur 2 zeigt einen Ausschnitt einer Bauelementanordnung 8 in einem Querschnitt. Die Bauelementanordnung 8 weist das keramische Bauelement 1 gemäß Figur 1 auf. Zudem weist die Bauelementanordnung 8 einen Träger 9 auf, in dem das Bauelement 1 eingebettet ist. Der Träger 9 ist als Leiterplatte ausgebildet. Der Träger 9 weist mehrere übereinander angeordnete Schichten 10, 11, 12 auf. Die Schichten 10, 11, 12 sind als Polymerschichten ausgebildet.

Beispielsweise ist das Bauelement 1 ganz im Inneren des Trägers 9 angeordnet. Insbesondere ist oberhalb und unterhalb des Bauelements 1 jeweils wenigstens eine Schicht 10, 12 des Trägers 9 vorhanden. Vorzugsweise ist das Bauelement 1 auf allen Seiten vom Polymermaterial des Trägers 9 umgeben. Das Bauelement 1 kann in mehrere Polymerschichten 11 eingebettet sein, die beispielsweise zwischen einer obersten und einer untersten Polymerschicht 10, 12 angeordnet sind.

Eine derartige Einbettung ermöglicht eine besonders platzsparende Anordnung eines elektrischen Bauelements 1 in einer Leiterplatte. Zudem gewährleistet der Träger 9 neben seiner Funktion als Leiterplatte auch einen Schutz des Bauelements 1 vor chemischen und/oder mechanischen Einflüssen. Darüber hinaus kann das Polymermaterial bei Übertemperaturen einen Temperaturausgleich bereitstellen.

Zur Weiterkontaktierung der Außenelektroden 5 ist jeweils eine Durchkontaktierung 13 ausgebildet, die durch wenigstens eine Schicht 12 des Trägers 9 zu einer Außenseite 15 des Trägers 9 führt. Die Durchkontaktierung 13 enthält Kupfer. Die Durchkontaktierung 13 ist beispielsweise in einem galvanischen Verfahren hergestellt.

Die Durchkontaktierung 13 ist mit einem Anschlusskontakt 14 verbunden, der auf der Außenseite 15, beispielsweise der Unterseite des Trägers 9, angeordnet ist. Der Anschlusskontakt 14 ist beispielsweise als Kontaktpad ausgebildet. Der Anschlusskontakt 14 weist beispielsweise Kupfer auf. Beispielsweise ist der Anschlusskontakt 14 durch Abscheiden eines Metalls aus einer Lösung, insbesondere durch ein galvanisches Verfahren, hergestellt.

Die andere Außenelektrode kann in analoger Weise mit einem Anschlusskontakt verbunden sein (nicht abgebildet).

### Bezugszeichenliste

- 1: elektrisches Bauelement
- 2: Grundkörper
- 3: Innenelektrode
- 4: Passivierungsschicht
- 5: Außenelektrode
- 6: erste Elektrodenschicht
- 7: zweite Elektrodenschicht
- 8: Bauelementanordnung
- 9: Träger
- 10: Polymerschicht
- 11: Polymerschicht
- 12: Polymerschicht
- 13: Durchkontaktierung
- 14: Anschlusskontakt
- 15: Außenseite

## Patentansprüche

1. Elektrisches Bauelement zur Einbettung in einen Träger (9), aufweisend einen keramischen Grundkörper (2), eine elektrisch isolierende Passivierungsschicht (4), die auf dem Grundkörper (2) aufgebracht ist, wenigstens eine Innenelektrode (3), die durch die Passivierungsschicht (4) hindurchgeführt ist, und eine Außenelektrode (5), die mit der Innenelektrode (3) verbunden ist, wobei die Außenelektrode (5) eine erste Elektrodenschicht (6) aufweisend ein Metall und eine darauf angeordnete zweite Elektrodenschicht (7) aufweist, wobei die zweite Elektrodenschicht (7) eine Kupferschicht ist und in einem galvanischen oder einem elektrochemischen Verfahren aufgebracht ist.

2. Elektrisches Bauelement nach dem vorhergehenden Anspruch,
bei dem die erste Elektrodenschicht (6) eine eingebrannte Paste aufweist.

3. Elektrisches Bauelement nach einem der vorhergehenden Ansprüche, bei dem die zweite Elektrodenschicht (7) direkt auf der ersten Elektrodenschicht (6) angeordnet ist.

4. Elektrisches Bauelement nach einem der vorhergehenden Ansprüche, bei dem die zweite Elektrodenschicht (7) zur Verbindung mit einer Weiterkontaktierung aus Kupfer ausgebildet ist.

5. Elektrisches Bauelement nach einem der vorhergehenden Ansprüche, bei dem die zweite Elektrodenschicht (7) die äußerste Schicht der Außenelektrode (5) ist.

6. Bauelementanordnung, aufweisend ein elektrisches Bauelement (1) nach einem der vorhergehenden Ansprüche und einen Träger (9), in dem das elektrische Bauelement (1) eingebettet ist.

7. Bauelementanordnung nach dem vorhergehenden Anspruch, bei dem der Träger (9) mehrere übereinander angeordnete Polymerschichten (10, 11, 12) aufweist.

8. Bauelementanordnung nach einem der Ansprüche 6 oder 7, aufweisend wenigstens eine Durchkontaktierung (13) zur elektrischen Kontaktierung des elektrischen Bauelements (1), wobei die Durchkontaktierung (13) durch den Träger (9) führt.

9. Bauelementanordnung nach einem der Ansprüche 6 bis 8, bei dem die Durchkontaktierung (13) Kupfer enthält.

10. Bauelementanordnung nach einem der Ansprüche 6 bis 9, aufweisend wenigstens einen Anschlusskontakt (14), der auf einer Außenseite (15) des Trägers (9) angeordnet ist, wobei der Anschlusskontakt (14) mit der Durchkontaktierung (13) verbunden ist.

11. Bauelementanordnung nach dem vorhergehenden Anspruch, bei dem der Anschlusskontakt (14), die Durchkontaktierung (13) und die zweite Elektrodenschicht (7) das gleiche Material aufweisen.

12. Bauelementanordnung nach einem der Ansprüche 8 bis 11, bei dem die Durchkontaktierung (13) galvanisch oder elektrochemisch hergestellt ist.

13. Verfahren zur Herstellung des elektrischen Bauelements nach einem der Ansprüche 1 bis 5,
aufweisend die folgenden Schritte:
A) Bereitstellen eines keramischen Grundkörpers (2) aufweisend Innenelektroden (3), der von einer elektrisch isolierenden Passivierungsschicht (4) umgeben ist, wobei die Innenelektroden (3) durch die Passivierungsschicht (4) hindurchgeführt sind,
B) Aufbringen einer ersten Elektrodenschicht (6) auf die Passivierungsschicht (4),
C) Aufbringen einer zweiten Elektrodenschicht (7), die eine Kupferschicht ist, auf die erste Elektrodenschicht (6) mittels eines galvanischen oder elektrochemischen Verfahrens.

14. Verfahren zur Herstellung einer Bauelementanordnung, aufweisend die folgenden Schritte:
A)-C) Herstellung eines elektrischen Bauelements (1) nach dem vorhergehenden Anspruch,
D) Bereitstellen von Schichten (10, 11, 12) zur Ausbildung eines Trägers (9), wobei wenigstens eine Schicht (10, 11, 12) eine Aussparung aufweist,
E) Anordnen der Schichten (10, 11, 12) übereinander und dabei Anordnen des Bauelements (1) in der Aussparung,
F) Verpressen der Schichten (10, 11, 12).

15. Verfahren nach Anspruch 14, mit den weiteren Schritten:
G) Einbringen wenigstens eines Lochs in wenigstens eine der Schichten (10, 11, 12),
H) Auffüllen des Lochs mit Kupfer zur Ausbildung einer Durchkontaktierung (13).

## Claims

1. Electrical component for embedding in a carrier (9), comprising a ceramic main body (2), an electrically insulating passivation layer (4) which is applied to the main body (2), at least one internal electrode (3) which is passed through the passivation layer (4), and an external electrode (5) which is connected to the internal electrode (3), wherein the external electrode (5) has a first electrode layer (6) containing a metal and a second electrode layer (7) arranged thereon, wherein the second electrode layer (7) is a copper layer and is applied using an electroplating or an electrochemical process.

2. Electrical component according to the preceding claim, in which the first electrode layer (6) comprises a fired paste.

3. Electrical component according to one of the preceding claims, in which the second electrode layer (7) is arranged directly on the first electrode layer (6).

4. Electrical component according to one of the preceding claims, in which the second electrode layer (7) is designed for connection to a further contact-connection of copper.

5. Electrical component according to one of the preceding claims, in which the second electrode layer (7) is the outermost layer of the external electrode (5).

6. Component arrangement comprising an electrical component (1) according to one of the preceding claims and a carrier (9) in which the electrical component (1) is embedded.

7. Component arrangement according to the preceding claim, in which the carrier (9) has a plurality of polymer layers (10, 11, 12) which are arranged one above the other.

8. Component arrangement according to one of Claims 6 or 7, comprising at least one plated-through hole (13) for making electrical contact with the electrical component (1), wherein the plated-through hole (13) passes through the carrier (9).

9. Component arrangement according to one of Claims 6 to 8, in which the plated-through hole (13) contains copper.

10. Component arrangement according to one of Claims 6 to 9, comprising at least one connection contact (14) which is arranged on an outer side (15) of the carrier (9), wherein the connection contact (14) is connected to the plated-through hole (13).

11. Component arrangement according to the preceding claim, in which the connection contact (14), the plated-through hole (13) and the second electrode layer (7) comprise the same material.

12. Component arrangement according to one of Claims 8 to 11, in which the plated-through hole (13) is produced by an electroplating or electrochemical process.

13. Method for producing the electrical component according to one of Claims 1 to 5, comprising the following steps:
A) providing a ceramic main body (2) comprising internal electrodes (3), which is surrounded by an electrically insulating passivation layer (4), wherein the internal electrodes (3) are passed through the passivation layer (4),
B) applying a first electrode layer (6) to the passivation layer (4),
C) applying a second electrode layer (7), which is a copper layer, to the first electrode layer (6) by means of an electroplating or electrochemical process.

14. Method for producing a component arrangement, comprising the following steps:
A) - C) producing an electrical component (1) according to the preceding claim,
D) providing layers (10, 11, 12) for forming a carrier (9), wherein at least one layer (10, 11, 12) has a cutout,
E) arranging the layers (10, 11, 12) one above the other and thereby arranging the component (1) in the cutout,
F) compressing the layers (10, 11, 12).

15. Method according to Claim 14, comprising the further steps of:
G) introducing at least one hole in at least one of the layers (10, 11, 12),
H) filling the hole with copper for forming a plated-through hole (13).

## Revendications

1. Composant électrique destiné à être enrobé dans un élément porteur (9), comprenant un corps de base en céramique (2), une couche de passivation (4) électriquement isolante qui est appliquée sur le corps de base (2), au moins une électrode interne (3) qui est passée à travers la couche de passivation (4), et une électrode externe (5) qui est reliée à l'électrode interne (3), l'électrode externe (5) possédant une première couche d'électrode (6) comportant un métal et une deuxième couche d'électrode (7) disposée sur celle-ci, la deuxième couche d'électrode (7) étant une couche de cuivre et étant appliquée dans un procédé galvanique ou électrochimique.

2. Composant électrique selon la revendication précédente, avec lequel la première couche d'électrode (6) possède une pâte incorporée par cuisson.

3. Composant électrique selon l'une des revendications précédentes, avec lequel la deuxième couche d'électrode (7) est disposée directement sur la première couche d'électrode (6).

4. Composant électrique selon l'une des revendications précédentes, avec lequel la deuxième couche d'électrode (7) est configurée en vue de la connexion avec un élément de mise en contact supplémentaire en cuivre.

5. Composant électrique selon l'une des revendications précédentes, avec lequel la deuxième couche d'électrode (7) est la couche la plus à l'extérieur de l'électrode externe (5).

6. Arrangement de composant, comprenant un composant électrique (1) selon l'une des revendications précédentes et un élément porteur (9) dans lequel est enrobé le composant électrique (1).

7. Arrangement de composant selon la revendication précédente, avec lequel l'élément porteur (9) possède plusieurs couches de polymère (10, 11, 12) disposées les unes au-dessus des autres.

8. Arrangement de composant selon l'une des revendications 6 ou 7, comprenant au moins un contact traversant (13) servant à l'établissement du contact électrique avec le composant électrique (1), le contact traversant (13) passant à travers l'élément porteur (9).

9. Arrangement de composant selon l'une des revendications 6 à 8, avec lequel le contact traversant (13) contient du cuivre.

10. Arrangement de composant selon l'une des revendications 6 à 9, comprenant au moins un contact de raccordement (14) qui est disposé sur un côté extérieur (15) de l'élément porteur (9), le contact de raccordement (14) étant relié au contact traversant (13).

11. Arrangement de composant selon la revendication précédente, avec lequel le contact de raccordement (14), le contact traversant (13) et la deuxième couche d'électrode (7) possèdent le même matériau.

12. Arrangement de composant selon l'une des revendications 8 à 11, avec lequel le contact traversant (13) est fabriqué par procédé galvanique ou électrochimique.

13. Procédé de fabrication du composant électrique selon l'une des revendications 1 à 5, comprenant les étapes suivantes :
A) fourniture d'un corps de base en céramique (2) qui possède des électrodes internes (3) et qui est entouré par une couche de passivation (4) électriquement isolante, les électrodes internes (3) étant passées à travers la couche de passivation (4),
B) application d'une première couche d'électrode (6) sur la couche de passivation (4),
C) application d'une deuxième couche d'électrode (7), qui est une couche de cuivre, sur la première couche d'électrode (6) au moyen d'un procédé galvanique ou électrochimique.

14. Procédé de fabrication d'un arrangement de composant, comprenant les étapes suivantes :
A)-C) fabrication d'un composant électrique (1) selon la revendication précédente,
D) fourniture de couches (10, 11, 12) en vue de former un élément porteur (9), au moins une couche (10, 11, 12) possédant un évidement,
E) disposition des couches (10, 11, 12) les unes au-dessus des autres et ici disposition du composant (1) dans l'évidement,
F) pressage des couches (10, 11, 12).

15. Procédé selon la revendication 14, comprenant les étapes supplémentaires suivantes :
G) incorporation d'au moins un trou dans au moins l'une des couches (10, 11, 12),
H) remplissage du trou avec du cuivre en vue de former un contact traversant (13).
